# EUROPEAN PATENT APPLICATION

(11) **EP 0 881 724 A2**
(43) Date of publication of application: **02.12.1998**
(21) Application number: 98107596.3
(22) Date of filing: 27.04.1998
(51) Int. Cl.: H01S 3/085

(54) **Vertical cavity surface emitting laser with archipelago like active region and method of fabrication**

(30) Priority: 01.05.1997 US 846452
(71) Applicant: MOTOROLA, INC., Schaumburg, IL 60196 (US)
(72) Inventor: Jiang, Wenbin, Phoenix, Arizona 85044 (US); Ramdani, Jamal, Gilbert, Arizona 852333 (US); Lebby, Michael S., Apache Junction, Arizona 85219 (US)
(74) Representative: Williamson, Simeon

(57) **Abstract**

A VCSEL (10) for use in high speed optical communications and a method of fabricating the VCSEL (10) including a substrate element (12), a first mirror stack (14) with mirror pairs lattice matched to an active region (20) with an archipelago-like active structure (23) sandwiched between a first cladding region (24) adjacent the first mirror stack (14) and a second cladding region (25). The archipelago-like active structure (23) including a plurality of island-like structures (35, 36 & 37), and a second mirror stack (26) lattice matched to the second cladding region (25). The archipelago-like active structure (23) formed by epitaxially growing layers of materials having different bandgaps and thereafter exposing the layers to a high temperature to form island-like structures separated by a different bandgap material.

## Description

### Field of the Invention

This invention relates to vertical cavity surface emitting lasers and more specifically to vertical cavity surface emitting lasers for high speed data communication.

### Background of the Invention

Vertical cavity surface emitting lasers (VCSEL) include a first distributed Bragg reflector (DBR), also referred to as a mirror stack, formed on top of a substrate by semiconductor manufacturing techniques, an active region formed on top of the first mirror stack, and a second mirror stack formed on top of the active region. The VCSEL is driven by a current forced through the active region, typically achieved by providing a first contact on the reverse side of the substrate and a second contact on top of the second mirror stack.

The use of mirror stacks in VCSELs is well established in the art. Typically, mirror stacks are formed of multiple pairs of layers often referred to as mirror pairs. The pairs of layers are formed of a material system generally consisting of two materials having different indices of refraction and being easily lattice matched to the other portions of the VCSEL. For example, a GaAs based VCSEL typically uses an AlAs/GaAs or AlGaAs/AlAs material system wherein the different refractive index of each layer of a pair is achieved by altering the aluminum content in the layers. In conventional devices, the number of mirror pairs per stack may range from 20-40 to achieve a high percentage of reflectivity, depending on the difference between the refractive indices of the layers. The large number of pairs increases the percentage of reflected light.

In conventional VCSELs, conventional material systems perform adequately. Typically, VCSELs utilizing conventional material systems and methods of fabrication exhibit a long pulse tail when modulated by a large electrical pulse. The root cause of the pulse tail is attributed to lateral carrier diffusion and spatial hole-burning in the VCSEL active region. As a result, the tail causes a power penalty in receiver designs when the VCSEL is used for high speed data communications. A direct effect of this pulse tail found in G-bit Ethernet applications is a reduced extinction ratio. Typically, a conventional VCSEL is obtained by using two-dimensional multiple quantum wells in the active region. Accordingly, the carriers can transport freely in the two-dimensional plane, thus leading to a long pulse tail. New products are being developed requiring VCSELs with minimal lateral carrier diffusion, thus a dramatic decrease in the length of the pulse tail. Such VCSELs are of great interest in the high speed data communication industry.

It would be highly advantageous, therefore, to remedy the foregoing and other deficiencies inherent in the prior art.

Accordingly, it is an object of the present invention to provide a new and improved VCSEL.

Another object of the invention is to provide a reliable VCSEL.

Still another object of the immediate invention is to provide an efficient active region for use in a VCSEL.

Yet another object of the invention is to reduce the complexity of fabricating a VCSEL having minimal lateral carrier diffusion.

Another object of the present invention is to provide an active region that limits lateral carrier movement for use in high speed data communication applications.

### Summary of the Invention

Briefly, to achieve the desired objects of the instant invention in accordance with a preferred embodiment thereof, provided is a VCSEL with an archipelago-like active region and a method of fabricating the same. The VCSEL includes a substrate element, a first mirror stack disposed on the substrate element, an active region defining a plurality of archipelago-like multiple quantum wells each isolated by a larger bandgap material, the active region being disposed on the first mirror stack, and a second mirror stack disposed on the active region.

The active region and the first and the second mirror stacks are configured to emit light with a wavelength in a range of approximately 650 nm to 1.55 micrometers.

### Brief Description of the Drawings

The foregoing and further and more specific objects and advantages of the instant invention will become readily apparent to those skilled in the art from the following detailed description of a preferred embodiment thereof taken in conjunction with the drawings, in which:
FIG. 1 is a sectional view of a VCSEL in accordance with the present invention; and
FIG. 2 is a further detailed sectional view further detailing the active region of the VCSEL of FIG. 1 in accordance with the present invention.

### Detailed Description of the Preferred Embodiment

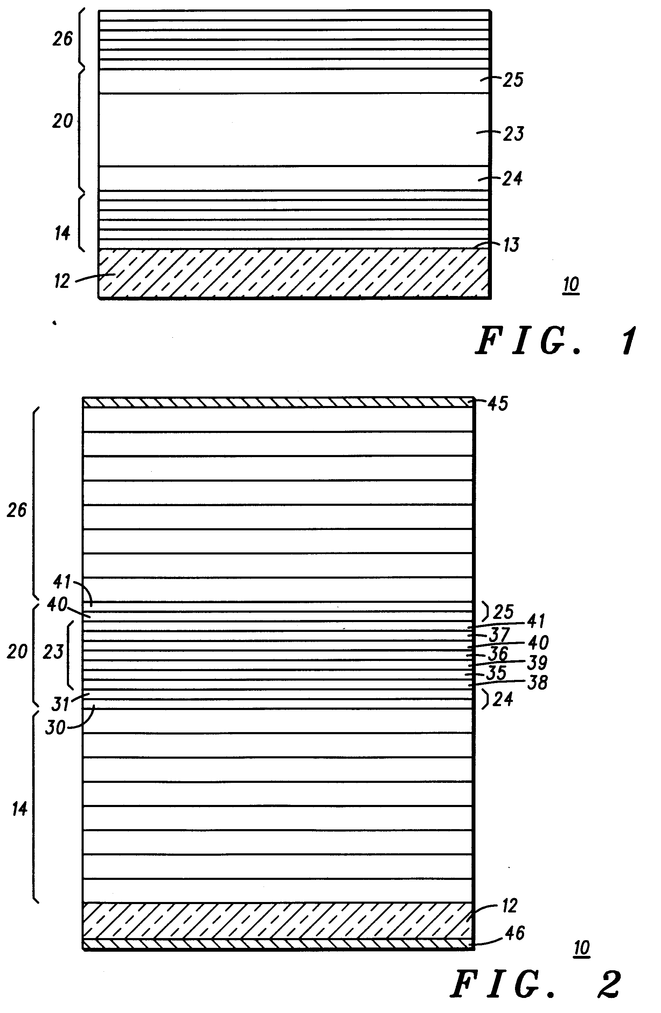

Turning now to the drawings in which like reference characters indicate corresponding elements throughout the several views, attention is first directed to FIG. 1 which illustrates a vertical cavity surface emitting laser (VCSEL) generally designated 10. In this particular embodiment, VCSEL 10 is fabricated to emit light having a wavelength of 850nm. It should however be understood that VCSEL 10 can be fabricated according to the method disclosed herein to emit light in a wavelength ranging from 650 nm to 1.55 µm dependent upon the material system used during the fabrication process.

VCSEL 10 is formed on a substrate 12, which in this specific embodiment, is GaAs. GaAs is used to facilitate epitaxial growth of the components of VCSEL 10 which emits light in a wavelength of approximately 850 nm. It should be understood that GaAs is further employed as substrate 12 in that the surface crystal orientation will allow for continuous wave (CW) operation at normal operating temperatures.

Substrate 12 has an upper surface 13 on which a mirror stack 14 is disposed. Mirror stack 14 includes a plurality of mirror pairs in a AlGaAs/AlGaAs material system. An active region 20 is disposed on mirror stack 14. Active region 20, as further detailed in FIG. 2, includes an active structure 23 sandwiched between a first cladding region 24 adjacent first mirror stack 14 and a second cladding region 25. A second mirror stack 26 is disposed on second cladding region 25 and includes mirror pairs in a AlGaAs/AlGaAs material system.

Mirror stack 14 is grown by epitaxially depositing pairs of layers on substrate 12. In order to crystal lattice match mirror stack 14 to substrate 12 a suitable semiconductor material system must be deposited. In this specific example, substrate 12 is GaAs and, therefore, an AlGaAs/AlGaAs material system is employed. Approximately 20-40 mirror pairs of this material system are deposited on substrate 12 depending on the difference between the refractive indices of the layers. The different refractive index of the layers of each pair is achieved by altering the aluminum content. In this specific embodiment, an Al_{0.15}Ga_{0.85}As layer and an Al_{0.85}Ga_{0.15}As layer forming a mirror pair is preferred. The large number of pairs increases the percentage of reflected light.

Cladding region 24 includes one or more layers which may be graded if necessary for more efficient carrier confinement in active structure 23. In this specific embodiment, cladding region 24 is formed of a AlGaAs material system. For example cladding region 24 includes a first layer 30 formed of Al_{0.5}Ga_{0.5}As to lattice match mirror stack 14, and a second layer 31 formed of a material having a gradient to efficiently confine the carriers in active structure 23.

Active structure 23, in this embodiment, includes three GaAs based archipelago-like multiple quantum well layers 35, 36, and 37, separated by barrier layers 38, 39, 40, and 41. Archipelago-like quantum well layers 35, 36, and 37 and barrier layers 38, 39, 40 and 41 are each approximately 100Å thick and the total thickness of active region 20 is approximately one wavelength of the emitted light or a multiple thereof. Archipelago-like quantum well layers 35, 36, and 37 are formed of GaAs. One skilled in the art will understand that more or fewer archipelago-like quantum well layers and barrier layers can be used depending upon the application.

During fabrication of active region 20 of VCSEL 10, a first barrier layer 38 is deposited on layer 31 of cladding region 24. Next, a layer of GaAs, approximately 100Å thick, is deposited on AlGaAs barrier layer 38. One mono-layer of AlAs is then deposited on the GaAs. To complete formation of active region 20, the layer of GaAs and the one mono-layer of AlAs, more particularly the wafer, is exposed to a temperature in excess of 500°C, more specifically to a temperature in excess of 700°C, to create a plurality of GaAs archipelago-like quantum wells, or island-like structures, as illustrated by reference numeral 35 of FIG. 2. Accordingly, once formed, the island-like structures are characterized by a having a specific bandgap and are separated by a larger bandgap material so that the carriers will be confined within each island-like structure. When this step is completed, a 100Å thick AlGaAs barrier layer 39 is deposited, and a second layer of 100Å thick GaAs and one mono-layer of AlAs are deposited to form a second layer 36 of archipelago-like quantum wells. The formation of the archipelago-like active structure 23 is repeated until three to four layers of GaAs islands are formed. A final barrier layer 41 is then deposited on the final GaAs island layer 37. This fabrication of a VCSEL is similar to the typical ridge wave guide type VCSEL formation, or the proton implant type formation of a VCSEL structure. It should be understood that alternative methods of fabricating the active layer are anticipated by this disclosure such as etching, regrowth, or the like.

In this specific embodiment, active region 20 and first and second mirror stacks 14 and 26 respectively are configured to emit light with a wavelength of approximately 850 micrometers. To achieve this range the archipelago-like quantum wells are GaAs and the barrier layers are Al_{0.3}Ga_{0.7}As.

Cladding region 25 includes one or more layers which may be graded if necessary for more efficient carrier confinement in active structure 23. In this specific embodiment, cladding region 25 is formed of a AlGaAs material system. For example cladding region 25 includes a first layer 40 formed of Al_{0.5}Ga_{0.5}As to lattice match mirror stack 26, and a second layer 42 formed of a material having a gradient from Al_{0.5}Ga_{0.5}As to Al_{0.3}Ga_{0.7}As continuously, to more efficiently confine carriers in active structure 23.

Mirror stack 26 is grown by epitaxially depositing pairs of layers on cladding region 25. In order to crystal lattice match mirror stack 26 to active structure 23, a suitable semiconductor material system must be deposited. In this specific example, cladding region 25 is AlGaAs based and, therefore, an AlGaAs/AlGaAs material system is employed. Approximately 20-40 mirror pairs of this material system are deposited on cladding region 25 depending on the difference between the refractive indices of the layers. The different refractive index of the layers of each pair is achieved by altering the aluminum content. In this specific embodiment, an Al_{0.15}Ga_{0.5}As layer and an Al_{0.85}Ga_{0.15}As layer forming a mirror pair is preferred. The large number of pairs increases the percentage of reflected light.

To complete VCSEL 10, a contact layer 45 is positioned on mirror stack 26, and a contact layer 46 is positioned on substrate 12, for example on the rear surface thereof. As will be understood by those skilled in the art contact 45 is so constructed as to permit the emission of light from VCSEL 10.

Various changes and modifications to the embodiments herein chosen for purposes of illustration will readily occur to those skilled in the art. For example, it should be understood that VCSEL structure symmetry exists for both p and n dopents as well as electrically inverted structure designs. To the extent that such modifications and variations do not depart from the spirit of the invention, they are intended to be included within the scope thereof which is assessed only by a fair interpretation of the following claims.

While we have shown and described specific embodiments of the present invention, further modifications and improvements will occur to those skilled in the art. We desire it to be understood, therefore, that this invention is not limited to the particular forms shown and we intend in the appended claims to cover all modifications that do not depart from the spirit and scope of this invention.

## Claims

1. A vertical cavity surface emitting laser characterized by:
a substrate (12);
a first mirror stack (14) disposed on the substrate (12);
an archipelago-like quantum well active region (20) disposed on the first mirror stack (14); and
a second mirror stack (26) disposed on the active region (20).

2. A vertical cavity surface emitting laser as claimed in claim 1 further characterized in that the active region (20) and the first (and the second mirror stacks (14 & 26) are configured to emit light with a wavelength in a range of approximately 650 micrometers to 1.55 micrometers.

3. A vertical cavity surface emitting laser as claimed in claim 1 further characterized in that the archipelago-like quantum well active region (20) includes at least one island-like structure layer (35, 36 & 37) including a first material having a specific bandgap and a second material having a bandgap larger than the bandgap of the first material.

4. A vertical cavity surface emitting laser as claimed in claim 3 further characterized in that the first material defines island-like structures during formation of the archipelago-like quantum well active region (20).

5. A vertical cavity surface emitting laser as claimed in claim 4 further characterized in that the island-like structures are separated by the second material having a larger bandgap.

6. A method of fabricating a vertical cavity surface emitting laser, the method characterized by the steps of:
providing a substrate (12) having a surface (13);
epitaxially growing a first mirror stack (14) on the surface (13);
epitaxially growing an archipelago-like active region (20) on the first mirror stack (14); and
epitaxially growing a second mirror stack (26) on the archipelago-like active region (20).

7. A method of fabricating a vertical cavity surface emitting laser as claimed in claim 6 further characterized in that the step of epitaxially growing an archipelago-like active region (20) includes the step of growing an active structure (23) sandwiched between a first cladding region (24) and a second cladding region (25).

8. A method of fabricating a vertical cavity surface emitting laser as claimed in claim 7 further characterized in that the step of growing the active structure (23) includes disposing a first layer of material having a specific bandgap on a first barrier layer (38), the first barrier layer (38) being disposed on the first cladding region (24) and disposing a second layer of material on the first layer of material, the second layer of material having a higher bandgap than the first layer of material.

9. A method of fabricating a vertical cavity surface emitting laser as claimed in claim 8 further characterized in that the step of growing the active structure (23) further includes the step of exposing the first layer of material and the second layer of material to a temperature in excess of 500°C, thereby forming a plurality of island-like structures from the first layer of material, the island-like structures separated by the second layer of material having a higher bandgap.

10. A method of fabricating a vertical cavity surface emitting laser as claimed in claim 9 further characterized in that the step of growing the active structure (23) further includes repeating the formation of island-like structure layers until at least three layers are formed.
